(19) Europäisches Patentamt
European Patent Office
Office européen des brevets

(11) **EP 2 414 820 B1**

## (12) EUROPÄISCHE PATENTSCHRIFT

(45) Veröffentlichungstag und Bekanntmachung des Hinweises auf die Patenterteilung:
**25.06.2014  Patentblatt 2014/26**

(21) Anmeldenummer: **10709173.8**

(22) Anmeldetag: **16.03.2010**

(51) Int Cl.:
**G01N 24/12** *(2006.01)*   **G01R 33/62** *(2006.01)*
**G01R 33/345** *(2006.01)*   **G01R 33/28** *(2006.01)*

(86) Internationale Anmeldenummer:
**PCT/EP2010/001651**

(87) Internationale Veröffentlichungsnummer:
**WO 2010/112137 (07.10.2010 Gazette 2010/40)**

(54) **DOPPELRESONANZSTRUKTUR UND VERFAHREN ZUR UNTERSUCHUNG VON PROBEN MIT MEHREREN LEITFÄHIGEN STREIFEN**

DUAL-RESONANCE STRUCTURE AND METHOD FOR EXAMINING SAMPLES USING A PLURALITY OF CONDUCTIVE STRIPS

STRUCTURE À DOUBLE RÉSONANCE ET PROCÉDÉ D'EXAMEN D'ÉCHANTILLONS DOTÉS DE PLUSIEURS RUBANS CONDUCTEURS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **03.04.2009  PCT/EP2009/002488**
**08.10.2009  DE 102009048636**

(43) Veröffentlichungstag der Anmeldung:
**08.02.2012  Patentblatt 2012/06**

(73) Patentinhaber: **Johann Wolfgang Goethe-Universität**
**60323 Frankfurt am Main (DE)**

(72) Erfinder:
• **PRISNER, Thomas**
**61118 Bad Vilbel (DE)**
• **DENYSENKOV, Vasyl**
**60439 Frankfurt am Main (DE)**

(74) Vertreter: **Lucke, Andreas**
**Boehmert & Boehmert**
**Pettenkoferstrasse 20-22**
**80336 München (DE)**

(56) Entgegenhaltungen:
**DE-A1-102008 017 135    JP-A- 2005 121 409**

• **Denysenkov V. et al: "New double resonance structures for high field DNP in liquids" 2nd Dynamic Nuclear Polarization Symposium 3. September 2009 (2009-09-03), Königstein, Germany Gefunden im Internet: URL:http://www.bio-dnp.uni-frankfurt.de/co ntent/ DNPSympAbstracts.pdf> [gefunden am 2010-04-22]**
• **WEIS V ET AL: "High-Field DNP and ENDOR with a Novel Multiple-Frequency Resonance Structure" JOURNAL OF MAGNETIC RESONANCE, ACADEMIC PRESS, ORLANDO, FL, US, Bd. 140, Nr. 1, 1. September 1999 (1999-09-01), Seiten 293-299, XP004407163 ISSN: 1090-7807 in der Anmeldung erwähnt**
• **BURGHAUS O ET AL: "A novel high-field/high-frequency EPR and ENDOR spectrometer operating at 3 mm wavelength" MEASUREMENT SCIENCE AND TECHNOLOGY, IOP, BRISTOL, GB, Bd. 3, Nr. 8, 1. August 1992 (1992-08-01), Seiten 765-774, XP020065284 ISSN: 0957-0233**
• **SINGEL D J ET AL: "A SPECTROMETER FOR EPR, DNP, AND MULTINUCLEAR HIGH-RESOLUTION NMR" JOURNAL OF MAGNETIC RESONANCE, ACADEMIC PRESS, ORLANDO, FL, US, Bd. 81, Nr. 1, 1. Januar 1989 (1989-01-01) , Seiten 145-161, XP000006752 ISSN: 1090-7807**

- SLOOP D J ET AL: "SPIN-ECHO-ENDOR STUDIES OF THE PHOTOEXCITED TRIPLET STATE OF PENTACENE IN P-TERPHENYL CRYSTALS AT ROOM TEMPERATURE" JOURNAL OF MAGNETIC RESONANCE, ACADEMIC PRESS, ORLANDO, FL, US, Bd. 86, Nr. 1, 1. Januar 1990 (1990-01-01), Seiten 156-159, XP000102281 ISSN: 1090-7807

- JOHANSSON B.: "A stripline resonator for ESR" REVIEW OF SCIENTIFIC INSTRUMENTS USA, Bd. 45, Nr. 11, November 1974 (1974-11), Seiten 1445-1447, XP002535682 GB ISSN: 0034-6748

**Beschreibung**

GEBIET DER ERFINDUNG

Die vorliegende Erfindung betrifft eine Doppelresonanzstruktur für DNP- und/oder ENDOR-Experimente nach dem Oberbegriff des Anspruchs 1. Ferner betrifft sie ein Verfahren zur Untersuchung von Proben mittels DNP- und/oder ENDOR nach dem Oberbegriff des Anspruchs 14, sowie ein DNP-NMR-Spektrometer, ein ENDOR-Spektrometer und ein kombiniertes DNP-NMR/ENDOR-Spektrometer.

HINTERGRUND DER ERFINDUNG

Die Kernspinresonanzspektroskopie (NMR-Spektroskopie, NMR = Nuclear magnetic resonance) ist eines der wichtigsten spektroskopischen Verfahren zur Aufklärung der Struktur und Dynamik von Molekülen, insbesondere in der organischen Chemie und in der Biochemie. Bei manchen Anwendungen, beispielsweise der Untersuchung von großen Biomolekülen in vitro und in vivo, stößt jedoch die Empfindlichkeit von NMR-Spektrometern an ihre Grenzen. Die mangelnde Empfindlichkeit kann zu einem gewissen Grade dadurch verbessert werden, dass ein höheres externes magnetisches Feld angelegt wird, aber dies ist nur in begrenztem Umfang und mit erheblichem Aufwand möglich.

Eine sehr vielversprechende Alternative, die Empfindlichkeit von NMR-Messungen beispielsweise bei Biomolekülen zu erhöhen, besteht in einem Verfahren, das als "dynamische Kernpolarisierung" bzw. "DNP-Verfahren" bekannt ist, entsprechend der Abkürzung des englischen Begriffs "dynamic nuclear polarisation". Die DNP resultiert aus der Übertragung von der Spinpolarisierung der Elektronen auf die Kerne nach dem so genannten "Overhauser-Effekt". Um sich die DNP in der NMR-Spektroskopie nutzbar zu machen, müssen zuerst die Elektronenspinpolarisationen auf das Kernspinsystem übertragen werden. Dazu wird die Probe mit einer Elektronenspinresonanzfrequenz, üblicherweise als EPR-Frequenz bezeichnet, angeregt, wobei "EPR" die Abkürzung für den englischen Begriff "electronic paramagnetic resonance" ist. Die EPR-Frequenz, auch Larmor-Frequenz genannt, entspricht der Aufspaltung der Energie von Elektronenspin-Energiequantenzuständen eines Atoms oder Moleküls in einem äußeren Magnetfeld nach dem Zeemann-Effekt, die ohne äußeres Magnetfeld entartet wären. Die Aufspaltung der Energiezustände ist proportional zur Stärke B des externen Magnetfeldes, und somit ist der Wert der EPR-Frequenz ebenfalls von der Stärke des äußeren Magnetfeldes abhängig. In praktisch relevanten Anwendungen liegt sie jedoch stets im Mikrowellenbereich. Die Veränderung der Polarisierung der Elektronenspins durch Einstrahlen von EPR-Mikrowellen wird oft auch anschaulich als "Pumpen" bezeichnet.

Die Verstärkung der NMR-Signale aufgrund der DNP ist, solange die EPR-Übergänge nicht gesättigt sind, proportional zum Quadrat der Intensität des EPR-Mikrowellenfeldes. Um ein EPR-Mikrowellenfeld mit möglichst hoher Leistung bzw. Feldstärke zu erhalten, werden daher vorzugsweise Mikrowellenresonatoren verwendet, in denen die Probe zur Stimulierung der EPR-Übergänge angeordnet wird.

Ähnlich wie die EPR basiert auch die Kernspinresonanz (NMR) auf Übergängen zwischen Quantenzuständen eines Spins in einem externen Magnetfeld, mit dem Unterschied, dass die Energieaufspaltung der Kernspins wesentlich kleiner ist als diejenige der Elektronenspins bei der EPR. Die NMR-Frequenzen liegen typischerweise im zweistelligen Megahertzbereich, also noch im Hochfrequenz-Bereich (HF-Bereich). Anstelle des Begriffes "Hochfrequenz" wird in der Literatur auch der Begriff "Radiofrequenz" verwendet. Der Begriff "Hochfrequenz" soll nicht darüber hinwegtäuschen, dass diese NMR-Frequenzen selbstverständlich die niedrigeren der beteiligten Frequenzen sind, nämlich niedriger sind als die oben genannten Mikrowellenfrequenzen.

Da auch für die NMR-Spektroskopie eine hohe Intensität des HF-Feldes notwendig ist, wird im Allgemeinen auch ein HF-Resonator in Form einer HF-Resonanzspule verwendet. Für DNP-NMR-Experimente bieten sich daher sogenannte Doppelresonanzstrukturen an, die einen Mikrowellen (MW)-Resonator für EPR-Übergänge und eine HF-Spule für NMR-Übergänge aufweisen, sodass dieselbe Probe gleichzeitig einem MW-Feld und einem HF-Feld mit hohen Intensitäten ausgesetzt werden kann.

Ein der DNP-NMR-Spektroskopie konzeptionell verwandtes Verfahren ist die sogenannte Elektronen-Kern-Doppelresonanz-Spektroskopie, die nach dem englischen Begriff "electron nuclear double-resonance" als "ENDOR-Spektroskopie" bezeichnet wird. Die ENDOR-Spektroskopie ist eine besondere Art der EPR-Spektroskopie, bei der NMR-Übergänge in der Probe durch Einstrahlen von HF-Feldern erzeugt werden. Insofern ist die ENDOR-Spektroskopie der DNP-NMR-Spektroskopie konzeptionell sehr ähnlich, nur dass bei dieser mit HF-Feldern "gepumpt" wird und EPR-Spektroskopie betrieben wird. Auch für ENDOR-Experimente wird eine Doppelresonanzstruktur gebraucht.

VERWANDTER STAND DER TECHNIK

Eine Doppelresonanzstruktur nach dem Oberbegriff des Anspruchs 1 ist aus dem Artikel von Weis et al. (High field DNP and ENDOR with novel multiple-frequency resonance structure, J. Magn. Reson. 140, 293-299 (1999)) bekannt. Diese vorbekannte Doppelresonanzstruktur umfasst einen zylindrischen Mikrowellenresonator, der aus einem schraubenförmig gewundenen leitenden Band gebildet ist. Das schraubenförmig gewundene leitende Band bildet dabei eine Spule, die die Funktion des HF-Resonators einnimmt. Der zylindrische MW-Resonator wird daher auch als Helix-Resonator bezeichnet. In der Mantelfläche der Helix ist eine Iris ausgebildet, durch die Mikrowellen in den Helix-Resonator eingespeist werden können. Die Länge des Resonators kann durch verstellbare Kolben eingestellt werden, die an beiden Enden der Helix in diese eingeführt sind.

In dem bekannten Helix-Resonator kann eine zylindrische $TE_{011}$ Mikrowellenmode angeregt werden, so dass eine recht hohe Mikrowellen-Energiedichte im MW-Resonator erreicht werden kann. Allerdings sind die Abmessungen des Helix-Resonators mit der Mikrowellenlänge korreliert, und wenn die Mikrowellenlänge entsprechend der EPR-Bedingung in starken externen Magnetfeldern unter einen Millimeter sinkt, begrenzt die geringe Größe des Helix-Resonators das Probenvolumen, das in dem Helix-Resonator untergebracht werden kann.

Im Falle von flüssigen, insbesondere wässrigen Proben besteht bei der Verwendung des bekannten Helix-Resonators ferner das Problem, dass dessen ohnehin schon begrenztes Volumen bei weitem nicht mit dem Probenvolumen ausgenutzt werden kann, weil sich die Probe unter Einstrahlung der Mikrowellen zu stark erwärmen würde. Grund für die starke Erwärmung ist die frequenzabhängige dielektrische Permitivität des Wassers bei Einstrahlung von Mikrowellen. Beispielsweise hat die komplexe dielektrische Permitivität von Wasser bei einer Mikrowellenfrequenz von 260 GHz einen Realteil $\varepsilon' = 5{,}6$ und einen Imaginärteil $\varepsilon'' = 5{,}8$, wobei die dielektrischen Verluste proportional zum Imaginärteil $\varepsilon''$ der Permitivität sind. Die verhältnismäßig starken Verluste, auch "Einfügungsverluste" genant, führen einerseits dazu, dass das MW-Feld in der Probe deutlich geringer ist als außerhalb, und andererseits dazu, dass sich die Probe stark erwärmt.

Wenn beispielsweise Biomoleküle in wässriger Lösung untersucht werden sollen, verbietet sich eine starke Erwärmung der Probe jedoch, da die Biomoleküle durch die Erwärmung zerstört werden könnten. Die Erfinder haben versuchsweise eine wässrige Probe in einer Kapillare mit einem Durchmesser von nur 0,1 mm verwendet und mussten feststellen, dass sich die Probe unter Einstrahlung von Mikrowellen um 90 °C erhöhte. Selbst bei einem Durchmesser von lediglich 0,05 mm der Kapillare ergab sich noch eine Erwärmung von 17 °C. Dies bedeutet, dass das Probevolumen stets verhältnismäßig klein gehalten werden muss, so dass der

$$\text{Füllfaktor } \eta = \frac{V_s \left\langle B_{HF}^2 \right\rangle_s}{V_{struk} \left\langle B_{HF}^2 \right\rangle_{struk}}$$

verhältnismäßig klein ist, was zu einer verringerten NMR-Empfindlichkeit führt. Hierbei ist $V_s$ das Volumen der Probe, $\left\langle B_{HF}^2 \right\rangle_s$ der Durchschnittswert der HF-Magnetfeldstärke $B_{HF}$ im Bereich der Probe, $V_{struk}$ das Volumen der

Struktur und $\left\langle B_{HF}^2 \right\rangle$ der Durchschnittswert der Magnetfeldstärke $B_{HF}$ des Feldes im Bereich der Struktur. Wenn die MW-Leistung verringert wird, um eine übermäßige Erwärmung der Probe zu verhindern, führt dies zu einer Schwächung der DNP und somit wiederum zu einer Verschlechterung der NMR-Empfindlichkeit.

Eine weitere Doppelresonanzstruktur, ein sogenannter Hohlraum-Resonator für ENDOR ist in der JP2005-121409 beschrieben. Der Resonator verwendet eine HF-Spule, die um die Probe gewickelt ist, die ihrerseits in einem MW-Hohlraum angeordnet ist. Diese Struktur ist für ENDOR-Spektroskopie geeignet, nicht jedoch für DNP-Anwendungen, weil die HF-Spule zu einer Störung der Verteilung des elektrischen MW-Feldes über dem Probenvolumen führt, was zu einer unvorteilhaften Erwärmung der Probe führt.

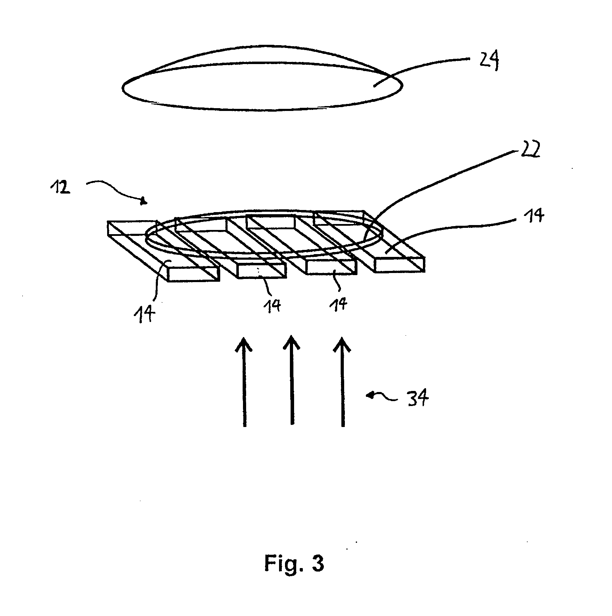

Aus Becerra L.R. et al.: "A Spectrometer for Dynamic Nuclear Polarization and Electron Paramagnetic Resonance at High Frequencies", Journal of Magnetic Resonance, Series A, 1995, vol. 117, S. 28-40, sind drei weitere DNP- und EPR-Spektrometer bekannt. Fig. 3 dieses Artikels zeigt ein erstes Spektrometer mit einer sich drehenden Probe, bei der Mikrowellenstrahlung in Richtung der Drehachse der Probe unter Verwendung eines Wellenleiters eingespeist wird. Die gesamte Probe ist von einer Spule umgeben, die einen NMR-Resonator bildet.

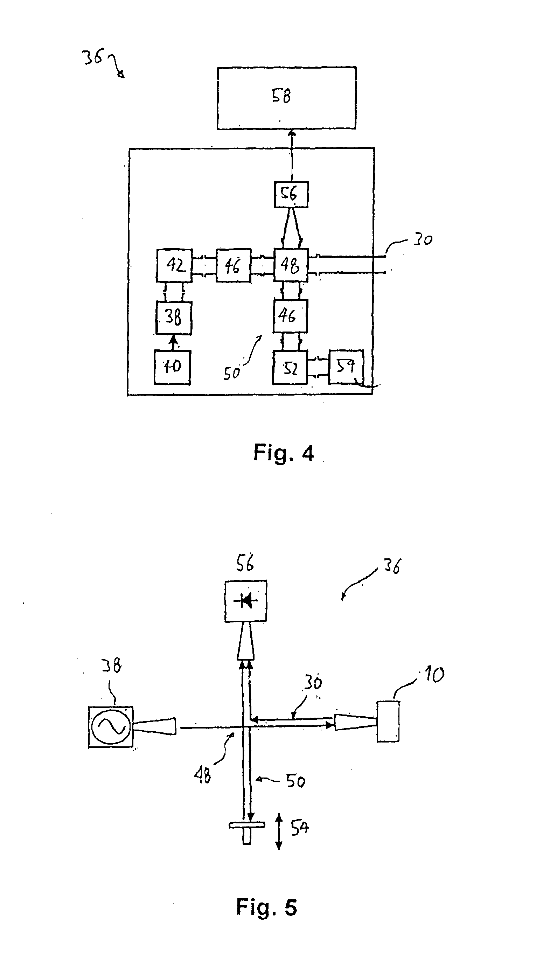

In Fig. 4 ist eine zweite statische DNP-Anordnung gezeigt, bei der sich ein Fabry-Perot-Spiegel und ein Wellenleiter gegenüberliegen, um einen Mikrowellenresonator zu bilden. Zum Erzeugen eines NMR-Feldes ist eine Spule vorgesehen, die einen HF-Resonator bildet. Die Mikrowellen werden zwischen zwei Spulenwindung in den Fabry-Perot-Resonator eingekoppelt. Schließlich zeigt Fig. 7 des Artikels eine dritte Doppelresonanzstruktur mit einem zylindrischen Mikrowellenresonator, und einer Spule, die einen HF-Resonator bildet und deren Längsachse senkrecht zur Längsachse des Mikrowellenresonators angeordnet ist.

In allen drei Ausführungsformen wird der HF-Resonator durch eine Spule gebildet. Ferner sind in allen drei Ausführungsformen der Mikrowellenresonator und der HF-Resonator jeweils baulich und funktionell getrennte Teile, die keine gemeinsame Komponente aufweisen. Nur die dritte Ausführungsform ist für ENDOR-Experimente geeignet.

In der nicht vorveröffentlichten Anmeldung DE 10 2008 017 135 ist eine Doppelresonanzstruktur beschrieben, bei der der HF-Resonator durch einen Streifen-Resonator gebildet wird, wobei ein Abschnitt des Streifen-Resonators gleichzeitig einen Teil des Mikrowellen-Resonators bildet.

ZUSAMMENFASSUNG DER ERFINDUNG

Der Erfindung liegt die Aufgabe zugrunde, eine Doppelresonanzstruktur und ein Verfahren zur Untersuchung von Proben mittels DNP-NMR- und/oder ENDOR anzugeben, die eine erhöhte Messempfindlichkeit gestatten.

Diese Aufgabe wird durch eine Doppelresonanzstruktur nach Anspruch 1 und ein Verfahren nach Anspruch 14 gelöst. Das Verfahren nach Anspruch 14 ist grundsätzlich aus dem Stand der Technik bekannt, zeichnet sich jedoch durch die Verwendung der erfindungsgemäßen Doppelresonanzstruktur aus. Vorteilhafte Weiterbildungen sind in den abhängigen Ansprüchen angegeben.

Die Doppelresonanzstruktur der Erfindung unterscheidet sich von derjenigen nach dem Stand der Technik dadurch, dass der HF-Resonator eine Mehrzahl von nebeneinander angeordneten elektrisch leitfähigen Streifen umfasst, die elektrisch so verbunden sind, dass ein HF-Strom in der Mehrzahl von Streifen derart erzeugbar ist, dass die HF-Ströme in den einzelnen Streifen gleichzeitig in dieselbe Richtung fließen, wobei ein Abschnitt des HF-Resonators gleichzeitig einen Teil des Mikrowellen-Resonators bildet.

Durch die HF-Ströme in den leitfähigen Streifen lassen sich HF-Felder für NMR-Übergänge mit ausreichender Stärke erzeugen. Gleichzeitig bilden die Streifen einen Abschnitt des Mikrowellen-Resonators. Bei den hier relevanten Mikrowellen-Frequenzen handelt es sich um so genannte "quasi-optische" Mikrowellen, und die nebeneinander angeordneten leitfähigen Streifen des HF-Resonators bilden einen Reflektor oder Spiegel für den Mikrowellen-Resonator, an dem die Mikrowellen quasi-optisch reflektiert werden. Dadurch wird eine, verglichen mit dem Helix-Resonator, offenere Struktur geschaffen, die im Hinblick auf Wärmedissipation vorteilhaft ist und es gestattet, größere Probenvolumina zu verwenden, als dies mit dem bekannten Helix-Resonator möglich ist.

Die Doppelresonanzstruktur der Erfindung unterscheidet sich ferner von der nicht vorveröffentlichten Doppelresonanzstruktur aus der DE 10 2008 017 135 dadurch, dass anstelle eines streifenförmigen HF-Resonators eine Mehrzahl von nebeneinander angeordneten Streifen verwendet wird, in denen der HF-Strom jedoch in dieselbe Richtung fließt. Dadurch kann die Breite der einzelnen Streifen wesentlich geringer gewählt werden, als wenn lediglich ein einzelner Streifenresonator verwendet wird, und gleichzeitig sichergestellt werden, dass die Gesamtbreite des HF-Resonators ausreichend groß ist, um einen Mikrowellen-Reflektor ausreichender Größe für den Mikrowellen-Resonator zu bilden.

Der Vorteil der Verwendung von schmaleren Streifen besteht darin, dass der so genannte "Conversion Factor" bzw. "Umwandlungsfaktor" des HF-Resonators erhöht wird. Der Conversion Factor ist ein Proportionalitätsfaktor zwischen der mit dem Resonator erreichbaren Magnetfeldstärke und der Quadratwurzel aus der zugeführten Leistung, sodass ein höherer Conversion Factor eine höhere Magnetfeldstärke gestattet. Ebenso führt ein erhöhter Conversion Factor zu einer erhöhten NMR-Messempfindlichkeit. Da der Conversion Factor wesentlich von der Breite des Streifenresonators begrenzt wird, ist es vorteilhaft, anstelle eines breiteren Streifenresonators eine Mehrzahl von schmaleren leitfähigen Streifenresonatoren nebeneinander anzuordnen, die gemeinsam als Reflektor für Mikrowellen als Teil des Mikrowellen-Resonators dienen können.

Vorzugsweise ist die Mehrzahl von leitfähigen Streifen parallel zueinander in Form eines Gitters angeordnet. Dabei ist der Abstand zwischen benachbarten leitfähigen Streifen vorzugsweise geringer als die Streifenbreite, und insbesondere geringer als die halbe Streifenbreite. Es hat sich gezeigt, dass ein aus leitfähigen Streifen gebildetes Gitter in der Tat einen deutlich höheren Coversion Factor erlaubt, als ein einzelner Streifenresonator gleicher Gesamtbreite, und dass das aus den leitfähigen Streifen gebildete Gitter gleichzeitig als Reflektor für den MW-Resonator geeignet ist.

Die leitfähigen Streifen können aus einem Metall hoher Leitfähigkeit bestehen. In einer bevorzugten Ausführungsform bestehen sie jedoch aus einem Verbundmaterial, dessen magnetische Suszeptibilität an diejenige einer zu untersuchenden Probe angepasst ist.

Vorzugsweise ist zumindest ein Teil der leitfähigen Streifen durch zusätzliche Leiter in Reihe geschaltet. Dabei ist vorzugsweise ein erstes Ende der Reihe aus in Reihe geschalteten Streifen mit Massepotential verbunden. Ferner ist vorzugsweise ein zweites Ende der Reihe aus in Reihe geschalteten Streifen über einen Kondensator, insbesondere einen einstellbaren Anpassungskondensator bzw. "Matching-Kondensator", mit einer HF-Quelle und/oder einem HF-Empfänger zum Erzeugen bzw. Detektieren eines NMR-Signals verbunden oder verbindbar.

In einer vorteilhaften Weiterbildung umfasst der MW-Resonator einen sphärischen Reflektor und einen ebenen Reflektor, die einander gegenüberstehen, wobei der ebene Reflektor durch einen Abschnitt des HF-Resonators gebildet wird. Ein derartiger MW-Resonator wird auch als "semikonfokaler Fabry-Perot-Resonator" bezeichnet. In dieser Anordnung hat der HF-Resonator eine dreifache Funktion:

Erstens erzeugt es ein HF-Feld, dessen Magnetfeldstärke $B_{HF}$ größer ist als beim bekannten Helix-Resonator, und größer als einer (nicht vorveröffentlichten) Ausführung mit einem einzigen Streifenresonator. Dies gestattet eine höhere NMR-Empfindlichkeit.

Zweitens dienen die nebeneinander angeordneten leitfähigen Streifen gemeinsam als Reflektor für den MW-Resonator, sodass die unterschiedlichen Resonatoren auf ideale Weise kombiniert werden können, ohne sich in ihrer Funktion gegenseitig zu beeinträchtigen. Die dadurch erhaltene Struktur bietet ausreichend Platz für Probenvolumina, die um einen Faktor zehn größer sein können, als bei dem üblicherweise verwendeten Helix-Resonator.

Und drittens wirkt die Mehrzahl von leitfähigen Streifen als Wärmesenke, durch die Wärme, die insbesondere beim Bestrahlen einer wässrigen Probe mit Mikrowellen erzeugt wird, abgeführt werden kann, sodass selbst verhältnismäßig große Probenvolumina verwendet werden können, ohne dass sie sich übermäßig erwärmen.

Vorzugsweise ist in dem sphärischen Reflektor eine Iris ausgebildet, durch die Mikrowellen in den MW-Resonator einspeisbar sind. Bei der Iris kann es sich um eine schlitzförmige Iris handeln, um linear polarisierte Mikrowellen in dem MW-Resonator zu erzeugen. Alternativ kann die Iris kreisförmig ausgebildet sein, um zirkular polarisierte Mikrowellenmoden in dem MW-Resonator zu erzeugen.

Alternativ können die Mikrowellen jedoch auch zwischen den leitfähigen Streifen des HF-Resonators hindurch in den MW-Resonator eingespeist werden. Dazu ist vorzugsweise ein Hornstrahler vorgesehen, der auf der dem MW-Resonator abgewandten Seite des HF-Resonators so angeordnet ist, dass er Mikrowellen durch Zwischenräume zwischen leitfähigen Streifen des HF-Resonators hindurch in den Mikrowellen-Resonator einkoppeln kann. Vorzugsweise werden dabei Mikrowellen mit einem Gauß'schen-Intensitätsprofil eingekoppelt.

Vorzugsweise sind der sphärische Reflektor und der ebene HF-Resonator so ausgebildet und angeordnet, dass sich eine $TEM_{00n}$-Mikrowellenmode zwischen ihnen ausbilden lässt. Vorzugsweise ist der Mikrowellen-Resonator ferner mit einer Mikrowellenquelle verbunden, die in der niedrigsten Strahlungsmode des MW-Resonators betreibbar ist.

Vorzugsweise ist bei der Doppelresonanzstruktur eine Stelle zur Aufnahme einer Probe vorgesehen, die mit dem HF-Resonator wärmeleitend verbunden ist. Dadurch dient der HF-Resonator gleichzeitig als Wärmesenke für die Probe, sodass das Problem der Erwärmung der Probe durch Wechselwirkung mit der Mikrowellenstrahlung wesentlich verringert werden kann und bei gleicher absoluter Erwärmung größere Probenvolumina verwendet werden können.

Vorzugsweise umfasst die Stelle zur Aufnahme einer Probe eine Einrichtung zur Aufnahme einer flüssigen Probe, wobei der Pegel der aufzunehmenden flüssigen Probe vorzugsweise bis zu einem Zehntel der Resonanzwellenlänge des Mikrowellen-Resonators beträgt. Dadurch lässt sich die Probe auf Bereiche beschränken, in denen die elektrische Komponente der stehenden Mikrowelle verhältnismäßig klein ist, wodurch eine übermäßige Erwärmung der Probe vermieden werden kann, wie unten anhand eines Ausführungsbeispiels näher erläutert wird.

In einer vorteilhaften Ausführungsform ist die Doppelresonanzstruktur als Sonde bzw. Probenkopf ausgebildet, die in eine Bohrung eines Magneten einführbar ist. Dieser Magnet, in den der Probenkopf einführbar ist, ist zum Erzeugen eines statischen Magnetfelds bestimmt, in dem die an sich entarteten Quantenzustände der Probe durch Wechselwirkung des Elektronspins bzw. Kernspins mit dem externen statischen Magnetfeld aufgespalten werden. Dabei hat der Probenkopf vorzugsweise ein Gehäuse, welches mit Massepotential verbunden ist.

Die hier beschriebene Doppelresonanzstruktur kann zu einem DNP-NMR-Spektrometer weitergebildet werden. Dazu sind eine Mikrowellenquelle, die zur Einspeisung von Mikrowellen in den MW-Resonator mit der Doppelresonanzstruktur verbunden ist und eine NMR-Einrichtung vorgesehen, die mit der Doppelresonanzstruktur zur Einspeisung von HF-Signalen in den HF-Resonator und zum Empfangen von HF-Signalen von dem HF-Resonator verbunden ist.

Ebenso kann die erfindungsgemäße Doppelresonanzstruktur zu einem ENDOR-Spektrometer weitergebildet werden, bei dem eine Mikrowellenquelle, die zur Einspeisung von Mikrowellen in den MW-Resonator und zum Empfangen von MW-Signalen aus dem MW-Resonator mit der Doppelresonanzstruktur verbunden ist, und eine HF-Quelle vorgesehen sind, die zum Einspeisen von HF-Signalen in den HF-Resonator mit der Doppelresonanzstruktur verbunden ist. Ferner kann die erfindungsgemäße Doppelresonanzstruktur in einem kombinierten DNP-NMR/ENDOR-Spektrometer verwendet werden, welches zu beiden Betriebsmodi in der Lage ist.

KURZBESCHREIBUNG DER FIGUREN

Weitere Vorteile und Merkmale der Vorrichtungen und des Verfahrens der Erfindung ergeben sich aus der folgenden Beschreibung, in der die Erfindung anhand eines Ausführungsbeispiels unter Bezugnahme auf die beigefügten Zeichnungen näher erläutert wird. Darin zeigen:

Fig. 1    eine perspektivische Ansicht einer Doppelresonanzstruktur nach einer Weiterbildung der Erfindung,

Fig. 2    eine Seitenansicht der Doppelresonanzstruktur von Fig. 1, in der Magnetfeldlinien $B_{HF}$ des HF-Feldes und Magnetfeldlinien $B_{MW}$ des MW-Feldes eingezeichnet sind,

Fig. 3    eine perspektivische Ansicht einer alternativen Ausführungsform der Doppelresonanzstruktur, bei der die Mikrowellen zwischen den leitfähigen Streifen des HF-Resonators eingekoppelt werden,

Fig. 4    eine schematische Darstellung der Komponenten einer Mikrowellenbrücke, und

Fig. 5    eine funktionelle Darstellung der Mikrowellenbrücke von Fig. 4.

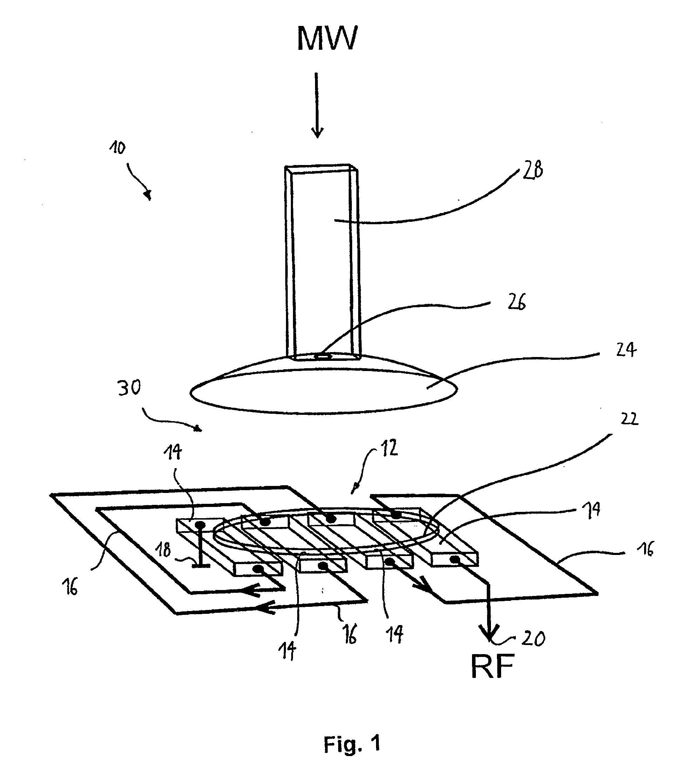

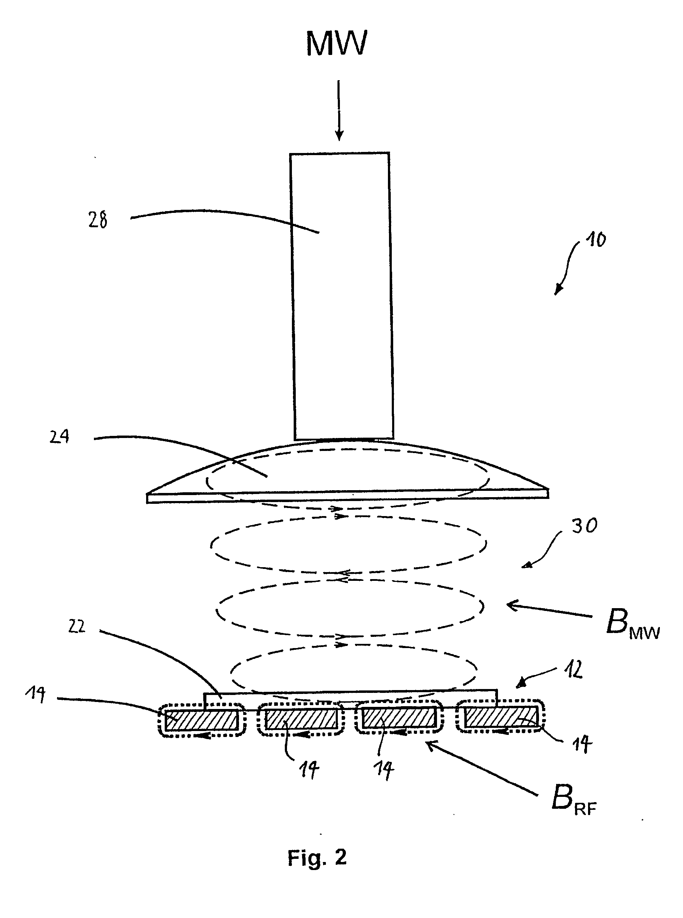

Fig. 1 zeigt eine Doppelresonanzstruktur 10 in einer perspektivischen Ansicht, in der die einzelnen Komponenten durchsichtig dargestellt sind. Fig. 2 zeigt eine Seitenansicht derselben Doppelresonanzstruktur 10, bei der Magnetfeldlinien $B_{HF}$ und $B_{MW}$ des HF-Feldes bzw. Mikrowellenfeldes eingezeichnet sind.

Die Doppelresonanzstruktur 10 umfasst einen HF-Resonator 12, der aus einer Mehrzahl - im gezeigten Ausführungsbeispiel vier - parallel zueinander und in einer Ebene nebeneinander angeordneten leitfähigen Streifen 14 besteht. Die leitfähigen Streifen 14 des HF-Resonators 12 sind durch weitere Leiter 16 in Reihe geschaltet. Ein erstes Ende 18 der Reihe aus in Reihe geschalteten Streifen 14 ist mit Massepotential verbunden. Ein zweites Ende 20 der Reihe aus in Reihe geschalteten leitfähigen Streifen 14 ist mit einer nicht gezeigten HF-Quelle oder einem nicht gezeigten HF-Empfänger zum Erzeugen bzw. Detektieren eines NMR-Signals verbindbar. Zwischen dem HF-Resonator 12 und der HF-Quelle bzw. dem HF-Empfänger kann noch ein Kondensator vorgesehen sein (in den Figuren nicht gezeigt), insbesondere ein einstellbarer Anpassungskondensator, auch "Matching-Kondensator" genannt.

Die leitfähigen Streifen 14 des HF-Kondensators 12 sind durch die zusätzlichen Leiter 16 so verbunden, dass der Stromfluss in den leitfähigen Streifen 14 stets in die gleiche Richtung gerichtet ist.

Auf den leitfähigen Streifen 14 ist eine Einrichtung 22 zur Aufnahme einer flüssigen Probe in Form eines flachen Behälters angeordnet. Der Behälter 22 liegt unmittelbar auf den leitfähigen Streifen 14 auf und ist somit wärmeleitend mit diesen verbunden. Der Behälter 22 kann beispielsweise zur Aufnahme einer wässrigen Probe dienen, in der zu untersuchende Biomoleküle enthalten sind. Die leitenden Streifen 14 können aus einem leitfähigen Verbundmaterial hergestellt sein, dessen magnetische Suszeptibilität an die magnetische Suszeptibilität der mit der Doppelresonanzstruktur 10 zu untersuchenden Proben angepasst ist.

Oberhalb des HF-Resonators 12 ist ein sphärischer Reflektor 24 angeordnet, in dem eine Iris 26 ausgebildet ist. Der sphärische Reflektor 24 ist mit einem Wellenleiter 28 verbunden, durch den Mikrowellen in den Zwischenraum zwischen dem HF-Resonator 12 und dem sphärischen Reflektor 24 eingespeist werden können. Die Iris 26 kann schlitzförmig sein, um linear polarisierte Mikrowellenmoden zu erzeugen, oder kreisförmig sein, um zirkular polarisierte Mikrowellenmoden zu erzeugen.

Der sphärische Reflektor 24 und der HF-Reflektor 12 bilden gemeinsam einen Mikröwelle-Resonator 30, der auch als semikonfokaler Fabry-Pérot-Resonator bezeichnet wird. Der Abstand zwischen dem sphärischen Reflektor 24 und dem HF-Resonator 12 ist einstellbar, so dass durch Verändern des Abstandes zwischen dem sphärischen Reflektor 24 und dem HF-Resonator 12 die Resonanzfrequenz des MW-Resonators 30 eingestellt werden kann.

Im Folgenden wird die Funktion der Doppelresonanzstruktur 10 von Figuren 1 und 2 beschrieben:

Der Begriff "Doppelresonanz" weist darauf hin, dass im Bereich des Probenbehälters 22 Resonanzbedingungen für zwei unterschiedliche elektronische Felder geschaffen werden. Die eine Resonanz betrifft die Resonanz des HF-Resonators 12, der mit einer Frequenz betrieben wird, die einer NMR-Resonanz in einem äußeren Magnetfeld $B_0$ entspricht. Bei einem externen Magnetfeld $B_0$ von rund 10 T beträgt die NMR-Frequenz beispielsweise rund 400 mHz.

Die Feldlinien im Hochfrequenz-Magnetfeld $B_{HF}$, welche von den einzelnen leitenden Streifen 14 des HF-Resonators erzeugt werden, sind in Fig. 2 schematisch dargestellt.

Die zweite Resonanz der Doppelresonanzstruktur bezieht sich auf eine Resonanz im Mikrowellenbereich, nämlich bei Frequenzen, die EPR-Übergängen entsprechen. Bei einem äußeren Magnetfeld $B_0$ von rund 10 T beträgt die EPR-Resonanz-Frequenz ca. 260 gHz. In dem MW-Resonator 30 können $TEM_{00n}$-Moden erzeugt werden, wobei n eine ganze Zahl ist. Die $TEM_{00n}$-Moden sind axialsymmetrisch, und das Feldprofil in einer Ebene parallel zur Oberfläche des HF-Resonators 12 hat eine Gauß'sche Form mit einer Breite, die vom Abstand vom sphärischen Reflektor 24 abhängt.

Das Magnetfeld $B_{MW}$ einer solchen Mode ist in Fig. 2 schematisch eingezeichnet. Die höchste Magnetfeldstärke des MW-Magnetfeldes $B_{MW}$ tritt unmittelbar an der Oberfläche des HF-Resonators, d.h. an der Oberfläche der leitfähigen Streifen 14 auf, d.h. dort, wo der Probenbehälter 22 angeordnet ist. Das nächste Maximum der Magnetfeldstärke $B_{MW}$ befindet sich eine halbe Wellenlänge oberhalb der Oberfläche des HF-Resonators 12. Der Probenbehälter 22 ist so flach gewählt, dass die maximale Dicke der Proben ungefähr 10 % der Resonanzwellenlänge des Mikrowellenfeldes beträgt. Bei größeren dicken der Probe würde diese auch in einem Bereich der stehenden Mikrowelle mit hohem elektrischen Feld liegen, wodurch die Probe übermäßig aufgeheizt würde und zudem der Gütefaktor Q des WM-Resonators 30 beeinträchtigt würde.

Da der Probenbehälter 22 unmittelbar auf den leitfähigen Streifen 14 des HF-Resonators 12 angeordnet ist, kann über diese Wärme von der Probe abgeführt werden. Dies ist ein besonderer Vorteil gegenüber beispielsweise einem Helix-Resonator, bei dem eine Erwärmung aufgrund von Mikrowellenabsorption nur schwer zu vermeiden ist, allenfalls durch sehr kleine Probenvolumina und geringe Mikrowellenleistung, was jedoch die Messgenauigkeit verringert.

Unter Ausnutzung der Doppelresonanz können DNP-NMR-Experimente oder ENDOR-Experimente durchgeführt werden. Bei DNP-NMR-Experimenten werden Elektronenspins in der Probe durch das Mikrowellenfeld polarisiert, und diese Polarisation wird nach dem Ovhauser-Effekt auf die Kernspins übertragen, wodurch sich bei Messung von NMR-Spektren ein erhöhtes NMR-Signal ergibt. Bei ENDOR-Experimenten tritt der umgekehrte Fall auf:

Die Probe wird mit NMR-Frequenzen angeregt, und es werden EPR-Spektren gemessen. Die Doppelresonanzstruktur 10 ist für beide Arten von Experimenten geeignet und kann somit als Sonden- oder Probenkopf sowohl für ein ENDOR-Spektrometer als auch für ein DNP-NMR-Spektrometer verwendet werden. Auch kann sie bei einer geeigneten Mikrowellenbrücke, die mit dem Mikrowellen-Wellenleiter 28 verbunden ist, und einer geeigneten NMR-Einrichtung, die mit dem zweiten Ende 20 der Reihenschaltung des HF-Resonators 12 verbunden ist, in einem kombinierten ENDOR/DNP-NMR-Spektrometer verwendet werden, welches wahlweise in beiden dieser Modi betrieben werden kann.

Wie aus Figuren 1 und 2 ersichtlich ist, ist der HF-Resonator 12 aus einer Mehrzahl nebeneinander angeordneter leitfähiger Streifen 14 aufgebaut, deren Breite jeweils im Vergleich zur Gesamtbreite des HF-Resonators 12 verhältnismäßig gering ist. Durch die geringe Breite der leitfähigen Streifen 14 des HF-Resonators 12 lässt sich der Conversion Factor des HF-Resonators 12 wesentlich erhöhen gegenüber einer Ausführung, bei der ein einzelner leitfähiger Streifen gleicher Gesamtbreite verwendet würde. Da der HF-Resonator 12 gleichzeitig als ebener Reflektor des MW-Resonators 30 dient, kann im Falle eines HF-Resonators mit nur einem Streifen dessen Breite nicht beliebig verkleinert werden, andernfalls wären die Mikrowellenverluste zu groß. Es hat sich jedoch herausgestellt, dass die gitterartig nebeneinander angeordneten leitfähigen Streifen 14 insgesamt einen ebenen MW-Reflektor ausreichender Qualität bilden, um einen funktionsfähigen WM-Resonator 30 zu schaffen, und gleichzeitig eine Veringerung der Breite der einzelnen Streifen 14 gestatten, die ihrerseits zu einem erhöhten Conversion Factor führt.

Im Endeffekt lässt sich somit ein HF-Resonator mit erhöhtem Conversion Factor und somit erhöhtem Magnetfeld $B_{HF}$ und erhöhter NMR-Empfindlichkeit erzielen, der gleichzeitig Teil eines voll funktionsfähigen MW-Resonators ist.

In Fig. 3 ist eine alternative Ausführungsform einer Doppelresonanzstruktur 32 schematisch gezeigt. Der Aufbau der Doppelresonanzstruktur 32 ist demjenigen der Doppelresonanzstruktur 10 von Figuren 1 und 2 grundsätzlich sehr ähnlich, so dass dieselben Bezugszeichen für entsprechende Komponenten verwendet werden. Man beachte, dass die zusätzlichen Leiter 16 zur Verbindung der leitfähigen Streifen 14 auch bei der Doppelresonanzstruktur 32 von Fig. 3 vorhanden sind, in der Figur jedoch der Übersichtlichkeit halber nicht eingezeichnet wurden. Der Unterschied der Ausführungsform von Fig. 3 besteht darin, dass bei der Doppelresonanzstruktur 32 die Mikrowellen nicht durch eine Iris im sphärischen Reflektor 24 eingekoppelt werden. Stattdessen werden die Mikrowellen durch die Zwischenräume zwischen den leitfähigen Streifen 14 des HF-Resonators 12 in den MW-Resonator 30 eingekoppelt. Die Mikrowellen können beispielsweise in Form eines Gauß'schen Strahls 34 von unterhalb des HF-Resonators 12 eingekoppelt werden, beispielsweise mit Hilfe eines Hornstrahlers (nicht gezeigt).

Ein Beispiel für eine geeignete Mikrowellenbrücke 36 ist in den Figuren 4 und 5 gezeigt. Figur 4 zeigt die wesentlichen Komponenten der Mikrowellenbrücke 36 in einem Blockschaltbild, und Figur 6 zeigt den funktionellen Aufbau der Mikrowellenbrücke 36.

Wie in Figur 4 zu sehen ist, umfasst die Mikrowellenbrücke 36 einen Mikrowellenoszillator 38, der mit einer Spannungsversorgung 40 verbunden ist. Ferner umfasst die Mikrowellenbrücke 36 einen mechanischen Mikrowellenschalter 42 und einen Attenuator 46. Ein Strahlteiler 48 ist vorgesehen, um das Mikrowellensignal zwischen einem Signal-Arm, nämlich dem Mikrowellen-Wellenleiter 30, der mit der Doppelresonanzstruktur 10 verbunden ist, und einem Referenz-Arm 50 aufzuspalten, der aus einem weiteren Attenuator 46, einem Wellen-Messgerät 52 und einem verstellbaren Reflektor 54 besteht. Ferner umfasst die Mikrowellenbrücke 36 einen Detektor 56, der mit einem Lock-In-Verstärker 58 verbunden ist. Die entsprechenden Komponenten sind in Figur 5 mit denselben Bezugszeichen bezeichnet.

Die Mikrowellenbrücke 36 von Figuren 4 und 5 kann in einem EPR-Detektionsmodus und einem DNP-Modus betrieben werden. Dazu ist die Mikrowellenbrücke 36, wie besonders in Figur 5 gut zu erkennen ist, als Michelson-Interferometer ausgebildet, wobei die EPR-Spektroskopie mit Hilfe eines Signals der vom Mikrowellen-Resonator 32 reflektierten Mikrowellen durchgeführt wird. Die höchste EPR-Empfindlichkeit kann erreicht werden, wenn der Strahlteiler 48 je eine Hälfte der einfallenden Leistung in den Referenz-Arm 50 und in den Signal-Arm, d.h. den Mikrowellen-Wellenleiter 30 leitet. Diese Aufspaltung der Leistung ist jedoch nicht optimal für den DNP-Modus, weil im DNP-Modus so viel Mikrowellenleistung wie möglich in die Doppelresonanzstruktur, also den Signal-Arm, eingespeist werden soll. Zu diesem Zweck kann der Strahlteiler 48 durch einen alternativen Strahlteiler ausgetauscht werden, der beispielsweise 99,5% der Leistung in den Signal-Arm (Wellenleiter 30) treten lässt und lediglich 0,5% der Leistung in den Referenz-Arm 50 ablenkt.

Im DNP-NMR-Modus ist der HF-Anschluss der Doppelresonanzstruktur 10, d.h. das zweite Ende 20 des HF-Resonators 12 mit einer herkömmlichen NMR-Einrichtung, einer sogenannten NMR-Konsole verbunden. Im ENDOR-Modus wird der HF-Anschluss statt mit der NMR-Konsole mit einer geeigneten HF-Quelle verbunden.

Wie in den obigen Ausführungsbeispielen gezeigt wurde, gestatten die Doppelresonanzstrukturen 10, 32 der vorliegenden Erfindung DNP-NMR- und ENDOR-Experimente mit sehr starken NMR- und EPR-Feldern und vergleichsweise großen Probenvolumina. Tatsächlich sind die Probenvolumina, die verwendet werden können, rund 10 Mal so groß wie beim eingangs beschriebenen Helix-Resonator aus dem Stand der Technik. Ein besonderer Vorteil der Doppelresonanzstrukturen 10, 32 besteht darin, dass sie sehr effektiv Wärme von der Probe abführen können, so dass sich beispielsweise Biomoleküle in wässriger Lösung trotz hoher absorbierter Mikrowellenleistung untersuchen lassen, ohne dass die Temperatur der Probe in unzulässigem Umfang ansteigt.

Dies macht die Doppelresonanzstrukturen 10, 32 insbesondere für die Untersuchung flüssiger bzw. wässriger Proben äußerst vorteilhaft. Ein weiterer besonderer Vorteil der Doppelresonanzstrukturen 10, 32 liegt in dem besonders hohen Conversion Factor des HF-Resonators 12, der durch die Verwendung mehrerer verhältnismäßig schmaler leitfähiger Streifen 14 ermöglicht wird, die gemeinsam einen MW-Reflektor ausreichender Breite für den MW-Resonator 30 bilden.

Die gezeigte Doppelresonanzstruktur eignet sich insbesondere für die Strukturanalyse von Biomolekülen (2D-NMR), kinetische Studien, da die Messzeiten deutlich verringert sind, die Analyse komplexer (Bio-)Molekül-Mischungen, beispielsweise die Analyse von Metaboliten, die Identifizierung und Überwachung von Verunreinigungen und für ein Liganden- und Biomarker-Screening. Ferner können mit der Doppelresonanzstrukturen 10, 32 auf vorteilhafte Weisung dynamische Molekülwechselwirkungen untersucht werden. Darüberhinaus ist die Doppelresonanzstruktur bei 2D- und 3D-Analysen von kondensierter Materie, beispielsweise geordneten Kristallen, Lipidschichten und Membranen geeignet und für die NMR-Mikroskopie verwendbar.

In einem ENDOR-Spektroskopie-Modus können die Doppelresonanzstrukturen 10, 32 auf vorteilhafte Weise bei der Untersuchung von Defekten in Halbleitern, Chiralitäten und endohedralen Komplexen (Fullerenen) verwendet werden.

BEZUGSZEICHENLISTE

| 10 | Doppelresonanzstruktur |
| 12 | HF-Resonator |
| 14 | leitfähiger Streifen des HF-Resonators 12 |
| 16 | zusätzlicher Leiter |
| 18 | erstes Ende des HF-Resonators 12 |
| 20 | zweites Ende des HF-Resonators 12 |
| 22 | Probenbehälter |
| 24 | sphärischer Reflektor |
| 26 | Iris |
| 28 | Wellenleiter |
| 30 | MW-Resonator |
| 32 | Doppelresonanzstruktur |
| 34 | Mikrowellen-Strahl |
| 36 | Mikrowellenbrücke |
| 38 | MW-Oszillator |
| 40 | Spannungsquelle |
| 42 | mechanischer Mikrowellenschalter |
| 46 | Attenuator |
| 48 | Strahlteiler |
| 50 | Referenz-Arm |
| 52 | Wellenmesseinrichtung |
| 54 | Reflektor |
| 56 | Detektor |
| 58 | Lock-In-Verstärker |

**Patentansprüche**

1. Doppelresonanzstruktur (32) für DNP-NMR und/oder ENDOR-Experimente,
mit einem Mikrowellen-Resonator (30) zur Erzeugung elektromagnetischer Felder, die für EPR geeignet sind,
und mit einem HF-Resonator (12) zur Erzeugung elektromagnetischer Felder, die für NMR geeignet sind, **dadurch gekennzeichnet,**
**dass** der HF-Resonator (12) eine Mehrzahl von nebeneinander angeordneten elektrisch leitfähigen Streifen (14) umfasst, die elektrisch so verbunden sind, dass ein HF-Strom in der Mehrzahl von Streifen (14) derart erzeugbar ist, dass die HF-Ströme in den einzelnen Streifen gleichzeitig in dieselbe Richtung fließen,
wobei ein Abschnitt des HF-Resonators (12) gleichzeitig einen Teil des Mikrowellen-Resonators (30) bildet, der als Reflektor für Mikrowellen dienen kann.

2. Doppelresonanzstruktur (10, 32) nach Anspruch 1, bei der die Mehrzahl von leitfähigen Streifen (14) parallel zueinander in Form eines Gitters angeordnet sind, wobei der Abstand zwischen benachbarten leitfähigen Streifen (14) vorzugsweise geringer, als die Streifenbreite, und vorzugsweise geringer als die halbe Streifenbreite ist.

3. Doppelresonanzstruktur (10, 32) nach einem der vorhergehenden Ansprüche, bei der zumindest ein Teil der leitfähigen Streifen (14) durch zusätzliche Leiter (16) in Reihe geschaltet sind, wobei vorzugsweise ein erstes Ende (18) der Reihe aus in Reihe geschalteten Streifen (14) mit Massepotential verbunden ist.

4. Doppelresonanzstruktur (10, 32) nach Anspruch 3, mit einem Kondensator, insbesondere einem einstellbaren Anpassungskondensator, bei der ein zweites Ende (20) der Reihe aus in Reihe geschalteten Streifen (14) über den Kondensator, mit einer HF-Quelle und/oder einem HF-Empfänger zum Erzeugen bzw. Detektieren eines NMR-Signals verbindbar ist.

5. Doppelresonanzstruktur (32) nach einem der vorhergehenden Ansprüche, bei der der Mikrowellen-Resonator (30) einen sphärischen Reflektor (24) und einen ebenen Reflektor für Mikrowellen umfasst, die einander gegenüberstehen, wobei der ebene Reflektor durch einen Abschnitt des HF-Resonators (12) gebildet wird.

6. Doppelresonanzstruktur (10) nach Anspruch 5, bei der in dem sphärischen Reflektor (24) eine Iris (26) ausgebildet ist, durch die Mikrowellen in den Mikrowellen-Resonator (30) einspeisbar sind, wobei die Iris (26) vorzugsweise schlitzförmig ist, um linear polarisierte Mikrowellenmoden in dem Mikrowellen-Resonator (30) zu erzeugen, oder kreisförmig ist, um zirkular polarisierte Mikrowellenmoden in dem Mikrowellen-Resonator (32) zu erzeugen.

7. Doppelresonanzstruktur (32) nach einem der Ansprüche 1 - 5, bei der Mikrowellen zwischen leitfähigen Streifen (14) des HF-Resonators (12) hindurch in den Mikrowellen-Resonator (30) einspeisbar sind, wobei die Doppelresonanzstruktur vorzugsweise einen Hornstrahler umfasst, der auf der dem Mikrowellen-Resonator (30) abgewandten Seite des HF-Resonators (12) so angeordnet ist, dass er Mikrowellen durch Zwischenräume zwischen leitfähigen Streifen (14) des HF-Resonators (12) hindurch in den Mikrowellen-Resonator (30) einkoppeln kann.

8. Doppelresonanzstruktur (32) nach Anspruch 5 oder 6, bei der der sphärische Reflektor (24) und der HF-Resonator (12) so ausgebildet und angeordnet sind, dass sich eine $TEM_{00n}$-Mikrowellenmode zwischen ihnen ausbilden lässt, und/oder bei der der Mikrowellen-Resonator (30) mit einer Mikrowellenquelle (34) verbindbar ist.

9. Doppelresonanzstruktur (32) nach einem der vorhergehenden Ansprüche, bei der eine Stelle (22) zur Aufnahme einer Probe vorgesehen ist, die mit dem HF-Resonator (12) wärmeleitend verbunden ist, wobei die Stelle zur Aufnahme einer Probe vorzugsweise eine Einrichtung (22) zur Aufnahme einer flüssigen Probe umfasst, Pegel die es gestattet, eine flüssige Probe aufzunehmen, deren vorzugsweise bis zu einem Zehntel der Resonanzwellenlänge des Mikrowellen-Resonators (30) beträgt.

10. Doppelresonanzstruktur (32) nach einem der vorhergehenden Ansprüche, die als Probenkopf ausgebildet ist, der in eine Bohrung eines Magneten einführbar ist.

11. DNP-NMR-Spektrometer, das Folgendes umfasst:

   eine Doppelresonanzstruktur (32) nach einem der Ansprüche 1 - 10,
   eine Mikrowellenquelle (36), die zur Einspeisung von Mikrowellen in den Mikrowellen-Resonator (30) mit der Doppelresonanzstruktur (32) verbunden ist, und
   eine NMR-Vorrichtung, die mit der Doppelresonanzstruktur (32) zur Einspeisung von HF-Signalen in den HF-Resonator (12) und zum Empfangen von HF-Signalen von dem HF-Resonator (12) verbunden ist.

12. ENDOR-Spektrometer, das Folgendes umfasst:

   eine Doppelresonanzstruktur (32) nach einem der Ansprüche 1 - 10,
   eine Mikrowelleneinrichtung (36), die zur Einspeisung von Mikrowellen in den Mikrowellen-Resonator (30) und zum Empfang von Mikrowellen von dem Mikrowellen-Resonator (30) mit der Doppelresonanzstruktur (32) verbunden ist, und
   eine HF-Quelle, die mit der Doppelresonanzstruktur (32) zur Einspeisung von HF-Signalen in den HF-Resonator (12) verbunden ist.

13. Kombiniertes DNP-NMR/ENDOR-Spektrometer, das Folgendes umfasst:

   eine Doppelresonanzstruktur (32) nach einem der Ansprüche 1 - 10,
   eine Mikrowellen-Einrichtung (36), die geeignet ist, in einem NMR-Modus Mikrowellen-Signale in den Mikrowellen-Resonator (30) der Doppelresonanzstruktur (32) einzuspeisen, und in einem ENDOR-Modus Mikrowellen in den Mikrowellen-Resonator (30) der Doppelresonanzstruktur (32) einzuspeisen und Mikrowellen-Signale von dem Mikrowellen-Resonator (30) zu empfangen und zu detektieren,
   und eine Hochfrequenz-Einrichtung, die geeignet ist, in einem NMR-Modus HF-Signale in den HF-Resonator (12) der Doppelresonanzstruktur (32) einzuspeisen, HF-Signale von dem HF-Resonator (12) zu empfangen und zu detektieren, und in einem ENDOR-Modus HF-Signale in den HF-Resonator (12) einzuspeisen.

14. Verfahren zur Untersuchung von Proben mittels DNP-NMR und/oder ENDOR,
   bei dem eine Probe in einer Doppelresonanzstruktur (32) angeordnet wird, die einen Mikrowellen-Resonator (30) und einen HF-Resonator (12) umfasst,
   mit Hilfe des Mikrowellen-Resonators (30) ein Mikrowellenfeld erzeugt wird, welches geeignet ist, EPR-Übergänge in der Probe zu induzieren, und
   mit Hilfe des HF-Resonators (12) ein HF-Feld erzeugt wird, welches geeignet ist, NMR-Übergänge in der Probe) zu induzieren, **dadurch gekennzeichnet,**
   **dass** der HF-Resonator (12) eine Mehrzahl von nebeneinander angeordneten leitfähigen Streifen (14) umfasst, in denen ein HF-Strom erzeugt wird, der in dem einzelnen Streifen (14) in dieselbe Richtung fließt, und wobei ein Abschnitt des HF-Resonators (12) gleichzeitig einen Teil des Mikrowellen-Resonators (30) bildet, der als Reflektor für Mikrowellen dient.

15. Verfahren nach Anspruch 14, bei dem der Mikrowellen-Resonator (30) einen sphärischen Reflektor (24) und einen ebenen Reflektor für Mikrowellen umfasst, die einander gegenüberstehen, wobei das Verfahren durch eines der folgenden Merkmale oder mehrere der folgenden Merkmale in Kombination miteinander ausgezeichnet ist:

- der ebene Reflektor wird durch einen Abschnitt des HF-Resonators (12) gebildet,
- in dem Mikrowellen-Resonator (30) wird eine $TEM_{00n}$-Mode erzeugt,
- die Probe ist flüssig,
- die Probe ist mit dem HF-Resonator (12) wärmeleitend in Kontakt,
- Mikrowellen werden zwischen leitfähigen Streifen (14) des HF-Resonators (12) hindurch in den Mikrowellen-Resonator (30) eingespeist oder in dem sphärischen Reflektor (24) ist eine Iris (26) ausgebildet, durch die Mikrowellen in den Mikrowellen-Resonator (30) eingespeist werden.

**Claims**

1. A double-resonance structure (32) for DNP-NMR and/or ENDOR experiments,
having a microwave resonator (30) for generating electromagnetic fields suitable for EPR, and having an HF resonator (12) for generating electromagnetic fields suitable for NMR, **characterized in that** the HF resonator (12) comprises a plurality of electrically conductive strips (14), which are arranged side by side and are electrically connected, so that an HF current can be generated in the plurality of strips (14), such that the HF currents flow simultaneously in the same direction in the individual strips, wherein a portion of the HF resonator (12) forms part of the microwave resonator (30) at the same time.

2. The double-resonance structure (10, 32) according to Claim 1, wherein the plurality of conductive strips (14) are arranged parallel to one another in the form of a grid, wherein the distance between neighboring conductive strips (14) is preferably smaller than the strip width and is preferably smaller than half the strip width.

3. The double-resonance structure (10, 32) according to any one of the preceding claims,
wherein at least some of the conductive strips (14) are connected in series by additional conductors (16), wherein a first end (18) of the series of series-connected strips (14) is preferably connected to ground potential.

4. The double-resonance structure (10, 32) according to claim 3, further comprising a capacitor, in particular an adjustable matching capacitor, wherein a second end (20) of the series of series-connected strips (14) is connectable via said capacitor to an HF source and/or to an HF receiver for generating and/or detecting an NMR signal.

5. The double-resonance structure (32) according to any one of the preceding claims, wherein the microwave resonator (30) comprises a spherical reflector (24) and a planar reflector for microwaves, these reflectors being opposite one another, such that the planar reflector is formed by a section of the HF resonator (12).

6. The double-resonance structure (10) according to claim 5, wherein an iris (26) is formed in the spherical reflector (24), through which microwaves can be fed into the microwave resonator (30), wherein the iris (26) is preferably in the form of a slot to create linearly polarized microwave modes in the microwave resonator (30), or in the form of a circle to create circularly polarized microwave modes in the microwave resonator (32).

7. The double-resonance structure (32) according to any one of claims 1-5, wherein microwaves can be fed into the microwave resonator (30) between conductive strips (14) of the HF resonator (12), wherein the double-resonance structure preferably also comprises a horn radiator which is arranged on the side of the HF resonator (12) facing away from the microwave resonator (30), so that it can input microwaves through interspaces between conductive strips (14) of the HF resonator (12) into the microwave resonator (30).

8. The double-resonance structure (32) according to claim 5 or 6, wherein the spherical reflector (24) and the HF resonator (12) are designed and arranged so that a $TEM_{00n}$ microwave mode can develop between them, and/or wherein the microwave resonator (30) is connectable to a microwave source (34).

9. The double-resonance structure (32) according to any one of the preceding claims, wherein a location (22) is provided for receiving a sample which is connected to the HF resonator (12) in a thermally conducting manner, wherein the location for receiving a sample preferably comprises a device (22) for receiving a liquid sample, said device allowing for receiving a liquid sample having a level that preferably amounts to up to one-tenth of the resonant wavelength of the microwave resonator (30).

10. The double-resonance structure (32) according to any one of the preceding claims, which is designed as a probe head which may be inserted into a borehole in a magnet.

11. A DNP-NMR spectrometer, comprising:

a double-resonance structure (32) according to any one of Claims 1-10,

a microwave source (36), which is connected to the double-resonance structure (32) for feeding microwaves into the microwave resonator (30), and

an NMR device, which is connected to the double-resonance structure (32) for feeding HF signals into the HF resonator (12) and for receiving HF signals from the HF resonator (12).

12. An ENDOR spectrometer, comprising:

a double-resonance structure (32) according to any one of Claims 1-10,

a microwave device (36) which is connected to the double-resonance structure (32) for feeding microwaves into the microwave resonator (30) and for receiving microwaves from the microwave resonator (30), and

an HF source, which is connected to the double-resonance structure (32) for feeding HF signals into the HF resonator (12).

13. A combined DNP-NMR/ENDOR spectrometer, comprising:

a double-resonance structure (32) according to any one of Claims 1-10,

a microwave device (36), which in an NMR mode is suitable for feeding microwave signals into the microwave resonator (30) of the double-resonance structure (32), and in an ENDOR mode is suitable for feeding microwaves into the microwave resonator (30) of the double-resonance structure (32) and for receiving and detecting microwave signals from the microwave resonator (30),

and a high-frequency device, which in an NMR mode is suitable for feeding HF signals into the HF resonator (12) of the double-resonance structure (32), for receiving and detecting HF signals from the HF resonator (12), and in an ENDOR mode is suitable for feeding HF signals into the HF resonator (12).

14. A method for investigating samples by means of DNP-NMR and/or ENDOR, wherein a sample is arranged in a double-resonance structure (32) comprising a microwave resonator (30) and an HF resonator (12), a microwave field is generated with the help of the microwave resonator (30), this field being suitable for inducing EPR transitions in the sample, and an HF field is generated with the help of the HF resonator (12), this field being suitable for inducing NMR transitions in the sample, **characterized in that** the HF resonator (12) comprises a plurality of conductive strips (14) arranged side by side in which an HF current is generated that flows in the same direction in the individual strips (14), and a section of the HF resonator (12) forms a part of the microwave resonator (30) at the same time.

15. The method according to Claim 14, wherein the microwave resonator (30) comprises a spherical reflector (24) and a planar reflector for microwaves which are opposite one another, wherein the method is further **characterized by** one or more of the following features in combination:

- the planar reflector is formed by a section of the HF-resonator (12),
- a $TEM_{00n}$ mode is generated in the microwave resonator (30),
- the sample is liquid,
- the sample is in heat-conducting contact with the HF resonator (12),
- microwaves are fed into the microwave resonator (30) between conductive strips (14) of the HF resonator (12), or an iris (26) is formed in the spherical reflector, through which microwaves are fed into the microwave resonator (30).

**Revendications**

1. Structure à double résonance (32) pour des expériences RMN-DNP et/ou ENDOR, comportant un résonateur à micro-ondes (30) pour la production de champs électromagnétiques qui conviennent à la résonance paramagnétique électronique (RPE), et comportant un résonateur HF (12) pour la production de champs électromagnétiques qui conviennent à la résonance magnétique nucléaire (RMN), **caractérisée en ce que** le résonateur HF (12) comporte une pluralité de bandes (14) électroconductrices disposées les unes à côté des autres, qui sont reliées électriquement de telle sorte qu'un courant HF peut être généré dans la pluralité de bandes (14), de telle sorte que les courants HF dans les différentes bandes circulent simultanément dans la même direction, une partie du résonateur HF (12) constituant en même temps une partie du résonateur à micro-ondes (30) qui peut faire fonction de réflecteur pour micro-ondes.

2. Structure à double résonance (10, 32) selon la revendication 1, dans laquelle la pluralité de bandes (14) conductrices sont disposées parallèlement entre elles en formant une grille, la distance entre les bandes (14) conductrices voisines étant de préférence inférieure à la largeur des bandes, et de préférence inférieure à la moitié de la largeur des bandes.

**3.** Structure à double résonance (10, 32) selon l'une quelconque des revendications précédentes, dans laquelle au moins une partie des bandes (14) conductrices est montée en série par des conducteurs (16) supplémentaires, de préférence une première extrémité (18) de la rangée de bandes (14) montées en série étant reliée au potentiel de masse.

**4.** Structure à double résonance (10, 32) selon la revendication 3, comportant un condensateur, en particulier un condensateur d'adaptation réglable, dans laquelle une deuxième extrémité (20) de la rangée de bandes (14) montées en série peut être reliée via le condensateur à une source HF et/ou un récepteur HF pour générer ou détecter un signal RMN.

**5.** Structure à double résonance (32) selon l'une quelconque des revendications précédentes, dans laquelle le résonateur à micro-ondes (30) comporte un réflecteur (24) sphérique et un réflecteur plan pour micro-ondes, situés face à face, ledit réflecteur plan étant formé par une partie du résonateur HF (12).

**6.** Structure à double résonance (10) selon la revendication 5, dans laquelle dans le réflecteur (24) sphérique est réalisé un iris (26), à travers lequel les micro-ondes sont injectées dans le résonateur à micro-ondes (30), ledit iris (26) étant réalisé de préférence en forme de fente pour générer dans le résonateur à micro-ondes (30) un mode de micro-ondes à polarisation linéaire, ou en forme de cercle pour générer dans le résonateur à micro-ondes (30) un mode de micro-ondes à polarisation circulaire.

**7.** Structure à double résonance (32) selon l'une quelconque des revendications 1 à 5, dans laquelle des micro-ondes peuvent être injectées dans le résonateur à micro-ondes (30) en passant à travers les bandes (14) conductrices du résonateur HF (12), ladite structure à double résonance comportant de préférence une antenne à cornet, qui est disposée sur le côté du résonateur HF (12) détourné du résonateur à micro-ondes (30), de telle sorte qu'elle peut injecter dans le résonateur à micro-ondes (30) des micro-ondes ayant passé à travers les espaces intermédiaires entre les bandes (14) conductrices du résonateur HF (12).

**8.** Structure à double résonance (32) selon la revendication 5 ou 6, dans laquelle le réflecteur (24) sphérique et le résonateur HF (12) sont configurés et disposés de telle sorte qu'un mode de micro-ondes $TEM_{00n}$ peut être réalisé entre ceux-ci et/ou dans laquelle le résonateur à micro-ondes (30) peut être relié à une source de micro-ondes (34).

**9.** Structure à double résonance (32) selon l'une quelconque des revendications précédentes, dans laquelle il est prévu un emplacement (22) pour le prélèvement d'un échantillon, qui est relié de manière thermoconductrice au résonateur HF (12), ledit emplacement pour le prélèvement d'un échantillon comportant de préférence un dispositif (22) pour le prélèvement d'un échantillon liquide, qui permet de prélever un échantillon liquide dont le niveau correspond de préférence à un dixième maximum de la longueur d'onde de résonance du résonateur à micro-ondes (30).

**10.** Structure à double résonance (32) selon l'une quelconque des revendications précédentes, qui est configurée sous forme de tête d'échantillon qui peut être introduite dans une forure d'un aimant.

**11.** Spectromètre RMN-DNP, comportant les éléments suivants :

une structure à double résonance (32) selon l'une quelconque des revendications 1 à 10,
une source de micro-ondes (36) qui est reliée à la structure à double résonance (32) pour injecter des micro-ondes dans le résonateur à micro-ondes (30), et
un dispositif RMN, qui est relié à la structure à double résonance (32) pour entrer des signaux HF dans le résonateur HF (12) et pour recevoir des signaux HF délivrés par le résonateur HF (12).

**12.** Spectromètre ENDOR, comportant les éléments suivants :

une structure à double résonance (32) selon l'une quelconque des revendications 1 à 10,
un dispositif à micro-ondes (36) qui est relié à la structure à double résonance (32) pour injecter des micro-ondes dans le résonateur à micro-ondes (30) et pour recevoir des micro-ondes émanant du résonateur à micro-ondes (30), et
une source HF, qui est reliée à la structure à double résonance (32) pour entrer des signaux HF dans le résonateur HF (12).

**13.** Spectromètre combiné RMN-DNP/ENDOR, comportant les éléments suivants :

une structure à double résonance (32) selon l'une quelconque des revendications 1 à 10,
un dispositif à micro-ondes (36) qui est apte à injecter dans un mode RMN des micro-ondes dans le résonateur à micro-ondes (30) de la structure à double résonance (32), et à injecter dans un mode ENDOR des micro-ondes dans le résonateur à micro-ondes (30) de la structure à double résonance (32), et à recevoir et à détecter des signaux micro-ondes délivrés par le résonateur à micro-ondes (30),
et un dispositif haute fréquence qui est apte à injecter dans un mode RMN des signaux HF dans le résonateur HF (12) de la structure à double résonance (32), à recevoir et à détecter des signaux HF délivrés par le résonateur HF (12), et à injecter dans un mode ENDOR des signaux HF dans le résonateur HF (12).

14. Procédé permettant d'examiner des échantillons au moyen de la RMN-DNP et/ou de l'ENDOR, dans lequel un échantillon est disposé dans une structure à double résonance (32) qui comporte un résonateur à micro-ondes (30) et un résonateur HF (12),
le résonateur à micro-ondes (30) permet de produire un champ de micro-ondes qui est apte à induire des transitions RPE dans l'échantillon, et
le résonateur HF (12) permet de produire un champ HF qui est apte à induire des transitions RMN dans l'échantillon,
**caractérisé en ce que**
le résonateur HF (12) comporte une pluralité de bandes (14) électroconductrices disposées les unes à côté des autres, dans lesquelles est généré un courant HF qui circule dans la même direction dans les différentes bandes (14), et une partie du résonateur HF (12) constituant en même temps une partie du résonateur à micro-ondes (30) qui peut faire fonction de réflecteur pour micro-ondes.

15. Procédé selon la revendication 14, dans lequel le résonateur à micro-ondes (30) comporte un réflecteur sphérique (24) et un réflecteur plan situés face à face, ledit procédé étant **caractérisé par** une des caractéristiques suivantes ou plusieurs des caractéristiques suivantes combinées entre elles :

- le réflecteur plan est formé par une partie du résonateur HF (12),
- un mode de micro-ondes $TEM_{00n}$ est généré dans le résonateur à micro-ondes (30),
- l'échantillon est liquide,
- l'échantillon est en contact thermoconducteur avec le résonateur HF (12),
- des micro-ondes sont injectées dans le résonateur à micro-ondes (30) en passant entre les bandes (14) conductrices du résonateur HF (12), ou dans le réflecteur sphérique (24) est réalisé un iris (26), à travers lequel les micro-ondes sont injectées dans le résonateur à micro-ondes (30).

MW

Fig. 1

**Fig. 2**

**Fig. 3**

36

58

56

42　46　48　　　　　30

38　　46

40　　50　52　59

## Fig. 4

56

36

38　　30　　10

48　　50

54

## Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2005121409 A

- DE 102008017135

**In der Beschreibung aufgeführte Nicht-Patentliteratur**

- **WEIS et al.** High field DNP and ENDOR with novel multiple-frequency resonance structure. *J. Magn. Reson.,* 1999, vol. 140, 293-299

- **BECERRA L.R. et al.** A Spectrometer for Dynamic Nuclear Polarization and Electron Paramagnetic Resonance at High Frequencies. *Journal of Magnetic Resonance, Series A,* 1995, vol. 117, 28-40